# EUROPEAN PATENT APPLICATION

(11) **EP 4 650 490 A1**
(43) Date of publication of application: **19.11.2025**
(21) Application number: 25152018.5
(22) Date of filing: 15.01.2025
(51) Int. Cl.: C25B 11/053, C25B 1/04, C25B 9/23, C25B 9/77, C25B 11/032, C25B 11/056, C25B 11/063, C25B 11/065, C25B 11/075, C25B 13/08

(54) **WATER ELECTROLYSIS CELL, WATER ELECTROLYSIS CELL STACK, AND MANUFACTURING METHOD OF WATER ELECTROLYSIS CELL**

(30) Priority: 17.05.2024 JP 2024081225
(71) Applicant: Kabushiki Kaisha Toshiba, Minato-ku Tokyo (JP); Toshiba Energy Systems & Solutions Corporation, Saiwai-ku Kawasaki-shi Kanagawa (JP)
(72) Inventor: Hidai, Shoichi, Yokohama-shi, Kanagawa (JP); Shiino, Keisuke, Yokohama-shi, Kanagawa (JP)
(74) Representative: Hoffmann Eitle

(57) **Abstract**

A water electrolysis cell according to an embodiment includes: an anode electrode including an anode catalyst layer in which anode catalyst sheets are stacked via a gap, each anode catalyst sheet containing iridium oxide and being in the form of a nanosheet; a cathode electrode including a cathode catalyst layer in which cathode catalyst sheets are stacked via a gap, each cathode catalyst sheet containing platinum and being in the form of a nanosheet; and an electrolyte membrane containing a hydrocarbon-based material, placed between the anode electrode and the cathode electrode.

## Description

### FIELD

Embodiments described herein relate generally to a water electrolysis cell, a water electrolysis cell stack, and a manufacturing method of a water electrolysis cell.

### BACKGROUND

Electrochemical cells have been actively researched recently. For example, among the electrochemical cells, the use a polymer electrolyte membrane water electrolysis cell (PEMEC) is expected to generate hydrogen in a large-scale energy storage system.

During operation of a water electrolyzer using a water electrolysis cell, a direct current is applied to the water electrolysis cell to electrolyze water supplied to an anode electrode. Protons (Hydrogen ions) are generated at the anode electrode by the hydrogen oxidation reaction. The Protons move through an electrolyte membrane to a cathode electrode, where hydrogen is generated by the hydrogen reduction reaction.

The water electrolysis cell is provided with a catalyst layer to promote electrolysis reaction. Perfluorosulfonic acid is generally used as an ionomer to improve proton conductivity in the catalyst layer and the electrolyte membrane. Perfluorosulfonic acid belongs to organic fluorine compound (PFAS) which is increasingly regulated as being harmful to both the environment and human health.

### BRIEF DESCRIPTION OF THE DRAWINGS

Fig. 1 is a schematic diagram showing an example of a water electrolyzer according to this embodiment.
Fig. 2 is a view showing a schematic structure of a water electrolysis cell stack shown in Fig. 1.
Fig. 3 is a cross-sectional view showing a schematic structure of a water electrolysis cell shown in Fig .2.

### DETAILED DESCRIPTION

A water electrolysis cell according to an embodiment comprises: an anode electrode including an anode catalyst layer in which anode catalyst sheets are stacked via a gap, each anode catalyst sheet containing iridium oxide and being in the form of a nanosheet; a cathode electrode including a cathode catalyst layer in which cathode catalyst sheets are stacked via a gap, each cathode catalyst sheet containing platinum and being in the form of a nanosheet; and an electrolyte membrane containing a hydrocarbon-based material, placed between the anode electrode and the cathode electrode.

A water electrolysis cell stack according to an embodiment comprises the aforementioned electrolysis cell.

A manufacturing method of a water electrolysis cell according to an embodiment comprises: preparing an anode electrode including an anode catalyst layer in which anode catalyst sheets are stacked via a gap, each anode catalyst sheet containing iridium oxide and being in the form of a nanosheet; preparing a cathode electrode including a cathode catalyst layer in which cathode catalyst sheets are stacked via a gap, each cathode catalyst sheet containing platinum and being in the form of a nanosheet; preparing an electrolyte membrane containing a hydrocarbon-based material; and placing the electrolyte membrane between the anode electrode and the cathode electrode and bonding the anode electrode and the cathode electrode to the electrolyte membrane.

A water electrolysis cell, a water electrolysis cell stack, and a manufacturing method of a water electrolysis cell according to this embodiment are described herebelow with reference to the drawings.

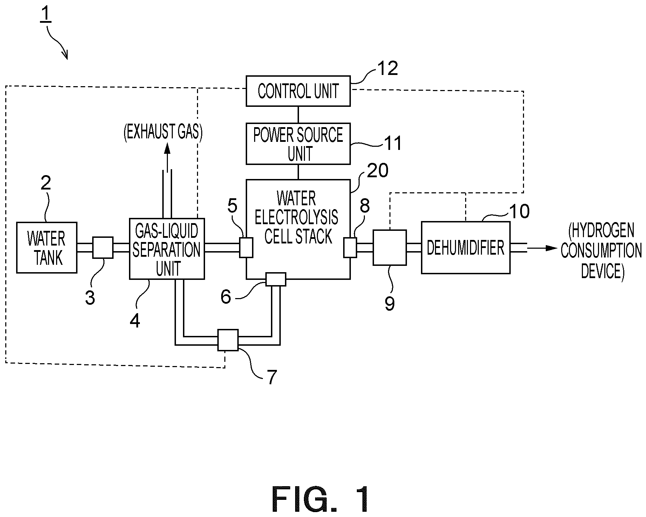

An example of a water electrolyzer to which the water electrolysis cell stack according to this embodiment is applied is firs described with the use of Fig. 1.

As shown in Fig. 1, the water electrolyzer 1 is an example of an apparatus that generates hydrogen and oxygen using an electrolyte membrane 33 described later. The water electrolyzer 1 includes a water electrolysis cell stack 20, a water tank 2, a supply pump 3, a gas-liquid separation unit 4, a water inlet manifold 5, a water outlet manifold 6, a circulation pump 7, a hydrogen manifold 8, a hydrogen gas-liquid separation unit 9, a dehumidifier 10, a power supply unit 11, and a control unit 12.

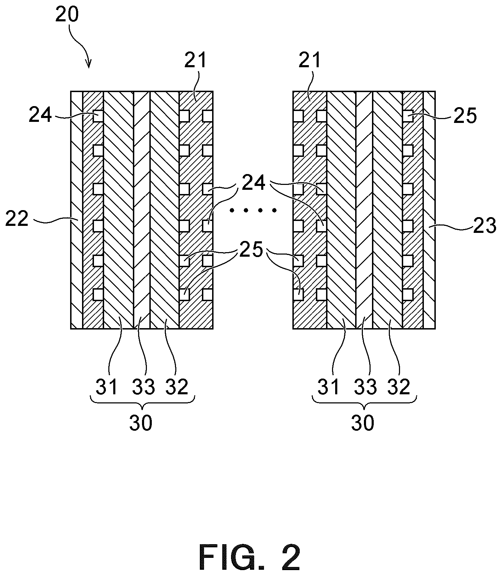

As shown in Fig. 2, the water electrolysis cell stack 20 is formed by stacking a plurality of water electrolysis cells 30. More specifically, the water electrolysis cell stack 20 includes a plurality of the water electrolysis cells 30, a plurality of separators 21, an anode current collector 22, and a cathode current collector 23. The water electrolysis cells 30, the separators 21, the anode current collector 22, and the cathode current collector 23 are tightened and pressed by a pair of clamping plates (not shown).

The water electrolysis cell 30 includes an anode electrode 31, a cathode electrode 32, and an electrolyte membrane 33. The water electrolysis cell 30 is also referred to as membrane electrode assembly.

As shown in Fig. 2, the separator 21 is interposed between the two water electrolysis cells 30. An anode path 24 is formed in a surface of the separator 21, which faces the anode electrode 31. The anode path 24 may include a plurality of grooves. A cathode path 25 is formed in a surface of the separator 21, which faces the cathode electrode 32. The cathode path 25 may include a plurality of grooves. The separator 21 is conductive and gas impermeable. The separator 21 separates an oxygen gas flowing through the anode path 24 and a hydrogen gas flowing through the cathode path 25.

The water electrolysis cell stack 20 is formed by stacking a plurality of the water electrolysis cells 30. However, not limited thereto, the water electrolysis cell stack 20 may be formed by one water electrolysis cell 30. Alternatively, a plurality of the water electrolysis cells 30 may be connected in parallel to form the water electrolysis cell stack 20.

The anode current collector 22 is connected to a positive pole of the power source unit 11, and the cathode current collector 23 is connected to a negative pole of the power source unit 11. When power is supplied from the power source unit 11, a direct current flows through each water electrolysis cell 30 of the water electrolysis cell stack 20, resulting in electrolysis reaction.

As shown in Fig. 1, the water tank 2 stores water to be supplied to the anode electrode 31 (see Fig. 2) of the water electrolysis cell stack 20. The water in the water tank 2 is supplied by the supply pump 3 to the water inlet manifold 5 through the gas-liquid separation unit 4.

The water inlet manifold 5 is configured to distribute the water supplied from the gas-liquid separation unit 4 to the anode paths 24 (see Fig. 2) of the respective separators 21. The water containing the oxygen gas, which is discharged from the respective anode paths 24, is collected in the water outlet manifold 6 and is supplied by the circulation pump 7 to the gas-liquid separation unit 4.

The gas-liquid separation unit 4 separates the oxygen gas and the water from the water containing the oxygen gas. The separated oxygen gas is discharged outside. The separated water, together with the water supplied from the water tank 2, is supplied to the water inlet manifold 5.

The hydrogen manifold 8 collects the hydrogen gas discharged from the cathode paths 25 (see Fig. 2) of the respective separators 21, and supplies it to the hydrogen gas-liquid separation unit 9. Since not only the hydrogen gas but also water is discharged from the cathode paths 25, the hydrogen gas supplied to the hydrogen gas-liquid separation unit 9 contains the water.

The hydrogen gas-liquid separation unit 9 separates the hydrogen gas and the water. The separated water is discharged outside. The separated hydrogen gas is supplied to the dehumidifier 10.

The dehumidifier 10 removes water vapor from the hydrogen gas discharged from the hydrogen gas-liquid separation unit 9. The hydrogen gas from which water vapor has been removed is supplied to a hydrogen consumption device. An example of the hydrogen consumption device may be a fuel cell.

The power source unit 11 supplies power to the aforementioned anode current collector 22 (see Fig. 2) and the cathode current collector 23. The control unit 12 controls the supply pump 3, the gas-liquid separation unit 4, the circulation pump 7, the hydrogen gas-liquid separation unit 9, and the dehumidifier 10 to optimize the operation of the water electrolyzer 1.

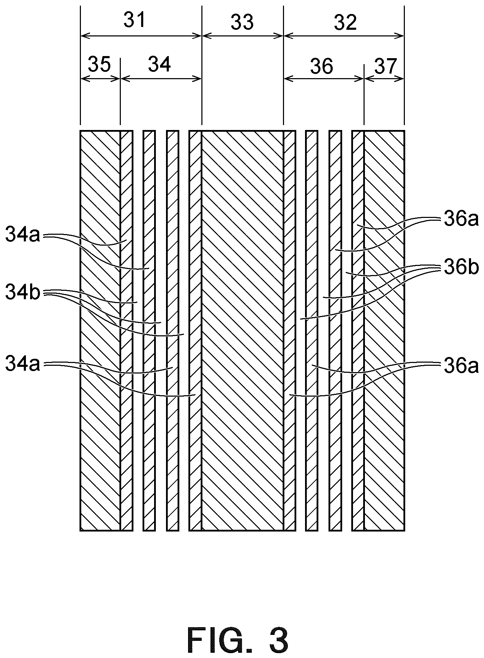

Details of the water electrolysis cell 30 are described using Fig. 3.

The anode electrode 31 includes an anode catalyst layer 34 and an anode diffusion layer 35. The anode catalyst layer 34 is consisted with multiple nano sheets applied on the surface of the fibers of the anode diffusion layers 35. The anode catalyst layer 34 is in contact with the electrolyte membrane 33. The anode diffusion layer 35 is in contact with the separator 21 and diffuses water supplied from the anode path 24 formed in the separator 21. The anode diffusion layer 35 is bonded to the anode catalyst layer 34. The anode electrode 31 does not have to contain any ionomer inside.

The anode catalyst layer 34 has a stack structure in which anode catalyst sheets 34a in the form of nanosheets are stacked via a gap 34b. Namely, the anode catalyst layer 34 includes a plurality of the anode catalyst sheets 34a, with the gap 34b being formed between two adjacent anode catalyst sheets 34a. The water flown from the water inlet manifold 5 into the anode path 24 enters the gap 34b of the anode catalyst layer 34 to generate protons (H⁺) and an oxygen gas (O₂) from the water (H₂O) by a reaction shown in the following formula (1). The generated oxygen gas, together with unreacted water, flows through the gap 34b to anode path 24 to be discharged to the aforementioned water outlet manifold 6. The generated protons move to the cathode electrode 32 through the electrolyte membrane 33.

2H₂O → 4H⁺ + 4e⁻ + O₂ (1)

The anode catalyst sheet 34a is a sheet that is made of a catalyst material and is in the form of nanosheets without ionomers. Two adjacent anode catalyst sheets 34a are partially integrated. This can ensure proton conductivity and can maintain the stack structure. As anode nanosheets is thin and attached to the electrolyte membrane 33, the proton can move to the electrolyte membrane 33 without ionomers. This can improve proton conductivity.

A thickness of the anode catalyst layer 34 may be, for example, 10 nm or more and 2000 nm or less. The anode catalyst layer 34 having a thickness of 10 nm or more can maintain the stack structure. The anode catalyst layer 34 having a thickness of 2000 nm or less can hold proton conductivity.

The anode catalyst sheet 34a may be formed of iridium oxide. The anode diffusion layer 35 may be formed of, for example, titanium nonwoven.

The cathode electrode 32 includes a cathode catalyst layer 36 and a cathode diffusion layer 37. The cathode catalyst layer 36 is in contact with the electrolyte membrane 33. The cathode diffusion layer 37 is in contact with the separator 21. The hydrogen gas generated by the electrolysis reaction is discharged from the cathode path 25 formed in the separator 21. The cathode electrode 32 does not have to contain any ionomer inside.

The cathode catalyst layer 36 has a stack structure in which cathode catalyst sheets 36a in the form of nanosheets are stacked via a gap 36b. Namely the cathode catalyst layer 36 includes a plurality of the cathode catalyst sheets 36a, with the gap 36b being formed between two adjacent cathode catalyst sheets 36a. At the cathode electrode 32, a hydrogen gas (H₂) is generated from the protons moved from the anode electrode 31 by a reaction shown in the following formula (2). The generated hydrogen gas flows through the cathode path 25 to be discharged to the aforementioned hydrogen manifold 8.

2H⁺ + 2e⁻ →H₂ (2)

As shown in Fig. 3, the cathode catalyst sheet 36a is a sheet that is made of a catalyst material and is in the form of a nanosheet without ionomer. Two adjacent cathode catalyst sheets 36a may be partially integrated. This can maintain the stack structure. Similarly to the anode catalyst layer 34, as the cathode nanosheet is thin and attached to the electrolyte membrane 33, the cathode catalyst layer 36 can hold the proton conductivity.

A thickness of the cathode catalyst layer 36 may be for example, 10 nm or more and 2000 nm or less. The cathode catalyst layer 36 having a thickness of 10 nm or more can maintain the stack structure. The cathode catalyst layer 36 having a thickness of 2000 nm or less can hold proton conductivity.

The cathode catalyst sheet 36a contains platinum (Pt). The cathode diffusion layer 37 may be formed of carbon paper or titanium nonwoven.

The electrolyte membrane 33 is placed between the anode electrode 31 and the cathode electrode 32, and is sandwiched between the anode electrode 31 and the cathode electrode 32. The electrolyte membrane 33 may be a polymer electrolyte membrane (PEM). The electrolyte membrane 33 is made of a hydrocarbon-based material. The hydrocarbon-based material may be a material that does not contain fluorine in the main chain and has a heat-resistant main chain. The hydrocarbon-based material may be a polymer having a functional group such as a sulfonic acid group, a carboxylic acid group, a phosphonic acid group, a phosphinic acid group, a sulfonylimide group, or a phenolic hydroxyl group. Specific examples of the hydrocarbon-based material may be polymers with sulfonated main-chain aromatic rings, such as polyarylenes, polyetheretherketones, polyethersulfones, polyphenylensulfides, polyimides, and polybenzazoles. A thickness of the electrolyte membrane 33 made of the hydrocarbon-based material may be 10 µm or more and 150 µm or less, or 13 µm or more and 40 µm or less.

Next, a manufacturing method of the water electrolysis cell 30 as structured above is described.

The aforementioned anode electrode 31, the cathode electrode 32, and the electrolyte membrane 33 are first prepared.

A production method of the anode electrode 31 is described. An anode catalyst sheet 34a containing iridium oxide and a sheet made of another metal material are alternately stacked on fibers of the diffusion layer by sputtering method. The metal material is removed by dissolving in an acid solution. Thus, the gap 34b is formed between two adjacent anode catalyst sheets 34a, so that the anode catalyst layer 34 in which the anode catalyst sheets 34a are stacked via the gap 34b is obtained.

A production method of the cathode electrode 32 is described. A cathode catalyst sheet 36a containing platinum and a sheet made of another metal material are alternately stacked on fibers of the cathode diffusion layer by sputtering method. The metal material is dissolvable in an acid solution. Thereafter, the metal sheet is dissolved in an acid solution (example of removal agent) to be removed. Thus, the gap 36b is formed between two adjacent cathode catalyst sheets 36a, so that the cathode catalyst layer 36 in which the cathode catalyst sheets 36a are stacked via the gap 36b is obtained.

Then, the electrolyte membrane 33 is placed between the anode electrode 31 and the cathode electrode 32, and the anode electrode 31 and the cathode electrode 32 are bonded to the electrolyte membrane 33. The anode electrode and the cathode electrode are applied to the membrane by hot pressing.

In this manner, the water electrolysis cell 30 according to this embodiment is obtained.

According to this embodiment, the anode electrode 31 includes the anode catalyst layer 34 in which the anode catalyst sheets 34a are stacked via the gap 34b, each anode catalyst sheet 34a containing iridium oxide and being in the form of a nanosheet. The cathode electrode 32 includes the cathode catalyst layer 36 in which the cathode catalyst sheets 36a are stacked via the gap 36b, each cathode catalyst sheet 36a containing platinum and being in the form of a nanosheet. The electrolyte membrane 33 placed between the anode electrode 31 and the cathode electrode 32 contains a hydrocarbon-based material. Proton conductivity of the hydrocarbon-based material can promote the movement of protons generated at the anode electrode 31 to the cathode electrode 32. This makes it possible to obtain the electrolyte membrane 33 that contains no organic fluorine compound but still can have proton conductivity.

In addition, according to this embodiment, the anode electrode 31 includes the anode catalyst layer 34 in which the anode catalyst sheets 34a are stacked via the gap 34b, each anode catalyst sheet 34a containing iridium oxide and being in the form of a nanosheet. This can increase a reaction area of water. In this case, the anode catalyst layer 34 can eliminate the need to contain an ionomer which is organic fluorine compound for improving proton conductivity. This allows the anode electrode 31 that contains no organic fluorine compound but still can promote a reaction water. In addition, the increased reaction area of water can reduce an amount of iridium used as a catalyst material. This can reduce the material cost of the anode electrode 31.

In addition, according to this embodiment, the cathode electrode 32 includes the cathode catalyst layer 36 in which the cathode catalyst sheets 36a are stacked via the gap 36b, each cathode catalyst sheet 36a containing platinum and being in the form of a nanosheet. This can increase an electrochemical reaction area of cathode catalyst to generate hydrogen. In this case, the cathode catalyst layer 36 can eliminate the need to contain an ionomer which is an organic fluorine compound for improving proton conductivity. This allows the cathode electrode 32 that contains no organic fluorine compound but still can promote a reaction of hydrogen. In addition, the increased electrochemical reaction area can reduce an amount of platinum catalyst. This can reduce the material cost of the cathode electrode 32.

Thus, this embodiment can provide the water electrolysis cell 30 that contains no organic fluorine compound but still can have proton conductivity. Since the water electrolysis cell 30 contains no organic fluorine compound, the water electrolysis cell 30 doesn't emitted the fluorine when it is recycled. This can make simple the recycling facility of the water electrolysis cell 30.

The aforementioned embodiment can provide proton conductivity without using organic fluorine compound.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the sprit of the inventions. The accompanying claims and their equivalents are intended to cover such forms or modifications as would fail within the scope and spirit of the invention.

## Claims

1. A water electrolysis cell comprising:
an anode electrode including an anode catalyst layer in which anode catalyst sheets are stacked via a gap, each anode catalyst sheet containing iridium oxide and being in the form of a nanosheet;
a cathode electrode including a cathode catalyst layer in which cathode catalyst sheets are stacked via a gap, each cathode catalyst sheet containing platinum and being in the form of a nanosheet; and
an electrolyte membrane containing a hydrocarbon-based material, placed between the anode electrode and the cathode electrode.

2. A water electrolysis cell stack comprising a water electrolysis cell according to claim 1.

3. A manufacturing method of a water electrolysis cell comprising:
preparing an anode electrode including an anode catalyst layer in which anode catalyst sheets are stacked via a gap, each anode catalyst sheet containing iridium oxide and being in the form of a nanosheet;
preparing a cathode electrode including a cathode catalyst layer in which cathode catalyst sheets are stacked via a gap, each cathode catalyst sheet containing platinum and being in the form of a nanosheet;
preparing an electrolyte membrane containing a hydrocarbon-based material; and
placing the electrolyte membrane between the anode electrode and the cathode electrode and bonding the anode electrode and the cathode electrode to the electrolyte membrane.

4. The manufacturing method of a water electrolysis cell according to claim 3, wherein
in the preparing of the anode electrode, the anode electrode is prepared by alternately stacking the anode catalyst sheet and a metal sheet, and by removing the metal sheet by a removal agent.

5. The manufacturing method of a water electrolysis cell according to claim 4, wherein
the anode catalyst sheet and the metal sheet are formed by sputtering.

6. The manufacturing method of a water electrolysis cell according to any one of claims 3 to 5, wherein
in the preparing of the cathode electrode, the cathode electrode is prepared by alternately stacking the cathode catalyst sheet and a metal sheet, and by removing the metal sheet by a removal agent.

7. The manufacturing method of a water electrolysis cell according to claim 6, wherein
the cathode catalyst sheet and the metal sheet are formed by sputtering.
